# EUROPÄISCHE PATENTSCHRIFT

(11) **EP 0 379 199 B1**
(45) Veröffentlichungstag und Bekanntmachung des Hinweises auf die Patenterteilung: **27.04.1994**
(21) Anmeldenummer: 90101020.7
(22) Anmeldetag: 18.01.1990
(51) Int. Cl.: H01L 27/02

(54) **ESD-Schutzstruktur**
ESD protection structure
Structure de protection ESD

(30) Priorität: 20.01.1989 DE 3901668
(43) Veröffentlichungstag der Anmeldung: 25.07.1990
(73) Patentinhaber: SIEMENS AKTIENGESELLSCHAFT, 80333 München (DE)
(72) Erfinder: Mitterer, Rudolf, Dipl.-Ing., D-8035 Gauting (DE); Soutschek, Ewald, Dr. Dipl.-Phys., D-8014 Neubiberg (DE); Nikutta, Wolfgang, Dipl.-Phys., D-8000 München 90 (DE)

(56) Entgegenhaltungen:
- EP-A- 0 034 929
- GB-A- 2 182 490
- PATENT ABSTRACTS OF JAPAN, Band 11, Nr. 209 (E-521)[2656], 7. Juli 1987; & JP-A-62 30 361
- PATENT ABSTRACTS OF JAPAN, Band 11, Nr. 59 (E-482)[2506], 24. Februar 1987; & JP-A-61 218 163
- PATENT ABSTRACTS OF JAPAN, Band 7, Nr. 186 (E-193)[1331], 16. August 1983; & JP-A-58 90 780
- PATENT ABSTRACTS OF JAPAN, Band 5, Nr. 149 (E-75)[821], 19. September 1981; & JP-A-56 81 966
- PATENT ABSTRACTS OF JAPAN, Band 3, Nr. 155 (E-160), 19. Dezember 1979, Seite 133 E 160; & JP-A-54 136 279
- ELECTRICAL OVERSTRESS/ELECTROSTATIC DISCHARGE SYMPOSIUM PROCEEDINGS, San Diego, California, US, 9.-11. September 1980, Seiten 73-80, IIT Research Institute; J.K. KELLER: "Protection of MOS integrated circuits from destruction by electrostatic discharge"
- PATENT ABSTRACTS OF JAPAN, Band 11, Nr. 165 (E-510)[2612], 27. Mai 1987; & JP-A-61 296 773

## Beschreibung

Die vorliegende Erfindung betrifft eine Schutzstruktur gegen elektrostatische Entladungen für eine Schaltungsanordnung in CMOS-Technologie in einem Halbleitersubstrat, wobei mindestens eine Diode und ein als RC-Glied wirkendes Siebglied zwischen ein Anschlußpad der Schaltungsanordnung und ein Versorgungspotential der Schaltungsanordnung geschaltet sind und wobei das Siebglied außerdem zwischen dem Anschlußpad und einem Schaltkreis der Schaltungsanordnung angeordnet ist.

Integrierte MOS-Schaltkreise sind an ihren Ein- und Ausgängen bekanntlich empfindlich gegenüber schnellen elektrostatischen Entladungen. Bereits in der Vergangenheit wurden deshalb Strukturen entwickelt, die einerseits die elektrische, signalmäßige Funktion des integrierten Schaltkreises möglichst wenig beeinflussen sollen und andererseits diesen vor der schädlichen Auswirkung der elektrostatischen Entladung schützen sollen. Entsprechende Strukturen nennt man "ESD-Schutzstruktur" (ESD = "electrostatic discharge").

Eine Schutzstruktur gemäß den obigen Ausführungen ist aus der Veröffentlichung Proceedings of the Electrical Overstress/Electrostatic Discharge Symposium, San Diego, California, US, 1980, Seiten 73 - 80, J. K. Keller: "Protection of MOS Integrated Circuits from Destruction by Electrostatic Discharge" bekannt. Bei der Verwendung einer solchen Schutzstruktur für Schaltungsanordnungen in CMOS-Technologie liegt ein parasitärer Thyristor vor. Der Thyristor kann bei einer elektrostatischen Entladung über die

Diode gezündet werden. Dadurch kann das Bauelement zerstört werden.

In JP-A 56 81 966 ist eine Schutzstruktur dargestellt, die zwei antiserielle Dioden enthält, die zwischen einen Anschlußpad und ein Versorgungspotential geschaltet sind. Dabei sind die Dioden nicht vollständig, sondern nur mit einem gemeinsamen Anschlußbereich in einem Substratbereich mit schwebendem Potential angeordnet. Auch bei der Verwendung dieser Schutzstruktur für Schaltungsanordnungen in CMOS-Technologie besteht Gefahr für Latch-up.

Aufgabe der vorliegenden Erfindung ist es, eine ESD-Schutzstruktur für Schaltungsanordnungen in CMOS-Technologie anzugeben, die eine geringe Empfindlichkeit gegen Latch-up aufweist.

Diese Aufgabe wird dadurch gelöst, daß zwei antiseriell geschaltete Dioden zwischen den Anschlußpad und ein Versorgungspotential geschaltet suind, wobei die zwei Dioden und der gemeinsame Anschlußbereich der Dioden in einem ersten Substratbereich eines ersten Leitfähigkeitstyps angeordnet sind, der auf einem elektrisch schwebenden Potential liegt und der in einem zweiten Substratbereich eines zweiten Leitfähigkeitstyps angeordnet ist.

Vorteilhafte Aus- und Weiterbildungen sind in Unteransprüchen gekennzeichnet. Die Erfindung wird im folgenden anhand der Zeichnung naher erläutert. Es zeigen:
- die FIG 1 und 4 bis 7: verschiedene Ausführungsformen der Erfindung,
- die FIG 2 und 3: im Querschnitt eine Einzelheit der Erfindung.

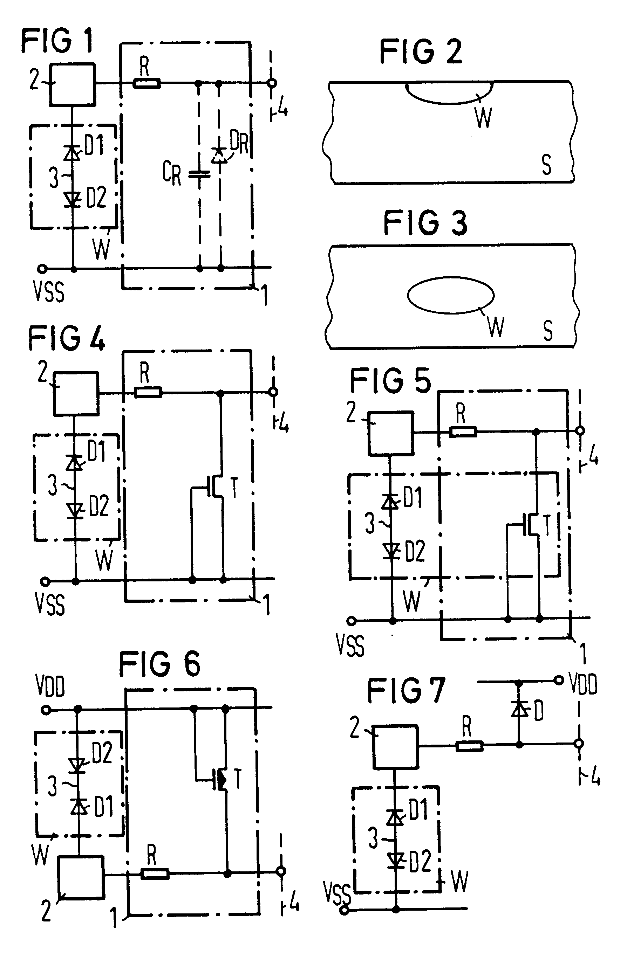

FIG 1 zeigt, funktionell-schematisiert dargestellt, ein Anschlußpad 2 einer Schaltungsanordnung. Zwischen dem Anschlußpad 2 und einem sonstigen, nicht näher dargestellten Teil 4 der Schaltungsanordnung ist die erfindungsgemäße ESD-Schutzstruktur angeordnet. Sie enthält als wesentliche Bestandteile zwei antiseriell geschaltete Dioden D1,D2 und, parallel dazu, ein Siebglied 1. Beide Bestandteile sind zwischen dem Anschlußpad 2 und einem Versorgungspotential VSS der Schaltungsanordnung angeordnet.

Bekanntlich ist bei CMOS-Technologie ein erster, meist wannenförmig ausgebildeter Substratbereich W von einem ersten Leitfähigkeitstyp in einem zweiten Substratbereich S angeordnet. Der Leitfähigkeitstyp des zweiten Substratbereiches S ist entgegengesetzt zum Leitfähigkeitstyp des ersten Substratbereiches W. Beim vorliegenden Beispiel ist nun die sogenannte p-well-CMOS-Technologie angenommen. Dies bedeutet, daß der erste Substratbereich W vom p-Leitfähigkeitstyp ist und daß der zweite Substratbereich S vom n-Leitfähigkeitstyp ist. In diesem Falle sind die Kathoden der Dioden D1,D2 mit dem Anschlußpad 2 bzw. dem Versorgungspotential VSS verbunden. Entsprechend sind die Anoden der beiden Dioden D1,D2 als gemeinsamer Anschlußbereich 3 zusammengeschaltet. Sie sind weiterhin im wannenförmigen ersten Substratbereich W angeordnet. Dieser weist ein elektrisch schwebendes Potential auf ("floatend").

In der Ausführungsform nach FIG 2 ist der erste Substratbereich W an einer Hauptfläche des zweiten Substratbereiches S angeordnet. In der Ausführungsform nach FIG 3 hingegen ist der erste Substratbereich W im zweiten Substratbereich S vergraben.

Vorteilhafterweise enthält das Siebglied 1 einen Widerstand R. Er ist zwischen dem Anschlußpad 2 und dem sonstigen Teil 4 der Schaltungsanordnung angeordnet. Er weist, wie üblich, einen kapazitiven Eigenanteil gegenüber dem zweiten Substratbereich S auf, der die Siebgliedwirkung im Sinne eines RC-Gliedes ermöglicht. Dies ist in FIG 1 gestrichelt dargestellt und mit dem Bezugszeichen C_{R} bezeichnet. Vorteilhafterweise ist der Widerstand R als Diffusionswiderstand oder als Widerstand aus Polysilizium realisiert; vorzugsweise mit einem Widerstandswert zwischen 500 Ohm und 1 kOhm.

Die Ausgestaltung als Diffusionswiderstand bietet den Vorteil einer einfachen Herstellung: Das Diffusionsgebiet kann gleichzeitig mit Diffusionsgebieten anderer elektronischer Bauelemente, beispielsweise von Transistoren der Schaltungsanordnung, hergestellt werden, ohne daß eine spezielle Metallisierung benötigt wird. Sie hat weiterhin den Vorteil geringen Flächenbedars aufgrund eines relativ hohen Bahnwiderstandes (verglichen beispielsweise mit einem Widerstand aus Polysilizium) und hoher thermischer Belastbarkeit. Weiterhin weist diese Art von Widerstand eine relativ hohe kapazitive Eigenwirkung auf (verglichen mit anderen Arten von Widerständen), wodurch sich zusammen mit der Eigenschaft "Widerstand" des Widerstandes R eine gute Siegliedwirkung des Siebgliedes 1 (RC-Glied) ergibt. Weiterhin besteht eine Diodenwirkung D_{R} (ebenfalls gestrichelt dargestellt) zum zweiten Substratbereich S hin.

Es entsteht dadurch folgende Wirkungsweise: Bei Auftreten eines ESD-Impulses am Anschlußpad 2 wird dieser zunächst bis auf eine kleine Restspannung durch die antiseriellen Dioden D1,D2 und die beschriebene RC-Eigenschaft des nachgeschalteten Siebgliedes 1 abgebaut und verzögert. Diese kleine Restspannung wird durch die Diodenwirkung D_{R} weiter abgebaut.

Bei Ausgestaltung als Widerstand aus Polysilizium kann im Betrieb die obengenannte Diodenwirkung nicht auftreten. Deshalb ist es vorteilhaft, wie in FIG 4 dargestellt, zwischen dem Widerstand R und dem Versorgungspotential VSS eine kapazitiv wirkende Diode vorzusehen, beispielsweise in Form einer gategesteuerten Diode, d.h. als Transistor T. Dessen Drain ist mit dem Widerstand R und dem sonstigen Teil 4 der Schaltungsanordnung verbunden. Source und Gate des Transistors T sind mit dem Versorgungspotential VSS verbunden. Der Leitungstyp des Transistors T ist derselbe wie der des zweiten Substratbereiches S. Dies bedingt, daß der Transistor T ebenfalls in einem Substratbereich (ähnlich dem wannenförmigen ersten Substratbereich W) angeordnet ist, der vom entgegengesetzten Leitungstyp ist wie der zweite Substratbereich S.

Vorteilhafterweise, da mit weniger Fertigungsaufwand verbunden, ist der Transistor T im selben ersten Substratbereich W angeordnet wie die beiden Dioden D1,D2. Dies ist in FIG 5 gezeigt.

FIG 6 zeigt eine erfindungsgemäße ESD-Schutzstruktur, bei der jedoch der zweite Substratbereich S vom p-Typ ist. Entsprechend ist der wannenförmige erste Substratbereich W vom n-Typ (n-well-CMOS-Technologie). Der Transistor T ist wiederum vom selben Typ wie der zweite Substratbereich S, d.h. also vom p-Typ. Auch die Anordnung der beiden Dioden D1,D2 ist umgekehrt zu den in den FIG 1, 4 und 5 gezeigten Anordnungen, bei denen der zweite Substratbereich S vom n-Typ ist. In der Anordnung nach FIG 6 sind die Kathoden der beiden Dioden D1,D2 als gemeinsamer Anschlußbereich 3 zusammengeschaltet, während die Anoden mit dem Anchlußpad 2 bzw. dem Versorgungspotential verbunden sind. Als Versorgungspotential ist nicht das Versorgungspotential VSS (vgl. FIG 1,4,5) gewählt, das ja nach allgemein üblicher Nomenklatur bei CMOS-Technologie das Bezugspotential "Masse" ist, sondern ein Versorgungspotential VDD, das, entsprechend der vorgenannten Nomenklatur, die übliche "Versorgungsspannung" darstellt und im allgemeinen +3 bis +7 V beträgt, bezogen auf das Potential VSS.

FIG 7 zeigt eine weitere vorteilhafte Ausführungsform der Erfindung. Dabei enthält die ESD-Schutzstruktur eine weitere Diode D, die zwischen dem Widerstand R und dem sonstigen Teil 4 der Schaltungsanordnung einerseits und einem weiteren Versorgungspotential VDD andererseits angeordnet ist (p-well-CMOS-Technologie sei wiederum angenommen). Das weitere Versorgungspotential VDD ist dasjenige Versorgungspotential einer integrierten Schaltungsanordnung, das zusammen mit dem Versorgungspotential VSS die Versorgungsspannung U der Schaltungsanordnung bildet. Damit lassen sich nach dem Siebglied 1 etwa noch auftretende ESD-Überschwingungsimpulse schnell und gefahrlos abbauen.

Eine entsprechende Anordnung ist, analog zur FIG 6, auch für die n-well-CMOS-Technologie gestaltbar.

Die Wirkungsweise der Erfindung läßt sich wie folgt beschreiben: Auftretende hohe ESD-Impulse werden in den Dioden D1,D2 abgebaut, da diese mangels eines Vorwiderstandes sehr hohe Ströme, und somit eine sehr hohe Verlustleistung aufnehmen können. Aufgrund des sehr schnellen Schaltverhaltens der Dioden D1,D2 entstehen somit nur sehr kurze Überspannungsimpulse, die nun vom Siebglied 1, das als RC-Glied wirkt, ausgefiltert werden. Der dabei auftretende Stromfluß wird durch den Widerstand R begrenzt. Wie beschrieben, wirken dabei der Widerstand R und/oder der Transistor T auch kapazitiv.

Die Vorteile der Erfindung lassen sich also, wie folgt, zusammenfassen:
- Hohe Festigkeit gegen ESD-Impulse,
- geringe Empfindlichkeit gegenüber Latch-up,
- minimale Leckströme,
- verwendbar sowohl bei n-well-CMOS- wie auch bei p-well-CMOS-Technologie.

## Patentansprüche

1. Schutzstruktur gegen elektrostatische Entladungen für eine Schaltungsanordnung in CMOS-Technologie in einem Halbleitersubstrat, wobei mindestens eine Diode und ein als RC-Glied wirkendes Siebglied (1) zwischen ein Anschlußpad (2) der Schaltungsanordnung und ein Versorgungspotential (VSS; VDD) der Schaltungsanordnung geschaltet sind und wobei das Siebglied außerdem zwischen dem Anschlußpad (2) und einem Schaltkreis (4) der Schaltungsanordnung angeordnet ist, **dadurch gekennzeichnet**, daß zwei antiseriell geschaltete Dioden (D1, D2) zwischen den Anschlußpad (2) und ein Versorgungspotential (VSS; VDD) geschaltet sind, wobei die zwei Dioden (D1, D2) und der gemeinsame Anschlußbereich (3) der Dioden (D1, D2) in einem ersten Substratbereich (W) eines ersten Leitfähigkeitstyps angeordnet sind, der auf einem elektrisch schwebenden Potential liegt und der in einem zweiten Substratbereich (S) eines zweiten Leitfähigkeitstyps angeordnet ist.

2. Schutzstruktur nach Anspruch 1, **dadurch gekennzeichnet**, daß der erste Substratbereich (W) an einer Hauptfläche des zweiten Substratbereiches (S) angeordnet ist.

3. Schutzstruktur nach Anspruch 1, **dadurch gekennzeichnet**, daß der erste Substratbereich (W) im zweiten Substratbereich (S) vergraben ist.

4. Schutzstruktur nach einem der vorhergehenden Ansprüche, **dadurch gekennzeichnet**, daß das Siebglied (1) einen Widerstand (R) enthält, der zwischen dem Anschlußpad (2) und dem Schaltkreis (4) der Schaltungsanordnung angeordnet ist.

5. Schutzstruktur nach Anspruch 4, **dadurch gekennzeichnet**, daß der Widerstand (R) eine kapazitive Wirkung (C_{R}) gegenüber dem zweiten Substratbereich (S) aufweist.

6. Schutzstruktur nach Anspruch 4 oder 5, **dadurch gekennzeichnet**, daß der Widerstand (R) ein Diffusionswiderstand ist.

7. Schutzstruktur nach Anspruch 6, **dadurch gekennzeichnet**, daß der Widerstand (R) eine diodenmäßige Wirkung (D_{R}) gegenüber dem zweiten Substratbereich (S) aufweist.

8. Schutzstruktur nach Anspruch 4 oder 5, **dadurch gekennzeichnet**, daß der Widerstand (R) im wesentlichen Polysilizium enthält.

9. Schutzstruktur nach einem der Ansprüche 4 bis 8, **dadurch gekennzeichnet**, daß der Wert des Widerstandes (R) zwischen 500 Ohm und 1 kOhm liegt.

10. Schutzstruktur nach einem der Ansprüche 4 bis 9, **dadurch gekennzeichnet**, daß das Siebglied (1) eine Diode, vorzugsweise eine gategesteuerte Diode wie einen Transistor (T) enthält, die zwischen dem Schaltkreis (4) der Schaltungsanordnung und dem Versorgungspotential (VSS;VDD) angeordnet ist.

11. Schutzstruktur nach Anspruch 10, **dadurch gekennzeichnet**, daß der Transistor (T) vom selben Leitfähigkeitstyp (n;p) ist wie der zweite Substratbereich (S).

12. Schutzstruktur nach Anspruch 10 oder 11, **dadurch gekennzeichnet**, daß der Transistor im selben ersten Substratbereich (W) angeordnet ist wie die antiseriellen Dioden (D1,D2).

13. Schutzstruktur nach einem der vorhergehenden Ansprüche, **dadurch gekennzeichnet**, daß sie eine weitere Diode (D) enthält, die mit dem Schaltkreis (4) der Schaltungsanordnung und einem weiteren Versorgungspotential (VDD; VSS) der Schaltungsanordnung angeordnet ist.

## Claims

1. Electrostatic discharge protection structure for a circuit arrangement using CMOS technology in a semiconductor substrate, at least one diode and one filter element (1), which acts as an RC element, being connected between a connecting pad (2) of the circuit arrangement and a supply potential (VSS; VDD) of the circuit arrangement, and the filter element additionally being arranged between the connecting pad (2) and a circuit (4) of the circuit arrangement, characterized in that two diodes (D1, D2), which are connected in series in opposition, are connected between the connecting pad (2) and the supply potential (VSS; VDD), the two diodes (D1, D2) and the common connecting region (3) of the diodes (D1, D2) being arranged in a first substrate region (W) of a first conductance type which is at an electrically floating potential and is arranged in a second substrate region (S) of a second conductance type.

2. Protection structure according to Claim 1, characterized in that the first substrate region (W) is arranged on a main surface of the second substrate region (S).

3. Protection structure according to Claim 1, characterized in that the first substrate region (W) is buried in the second substrate region (S).

4. Protection structure according to one of the preceding claims, characterized in that the filter element (1) contains a resistor (R) which is arranged between the connecting pad (2) and the circuit (4) of the circuit arrangement.

5. Protection structure according to Claim 4, characterized in that the resistor (R) has a capacitive effect (C_{R}) with respect to the second substrate region (S).

6. Protection structure according to Claim 4 or 5, characterized in that the resistor (R) is a diffusion resistor.

7. Protection structure according to Claim 6, characterized in that the resistor (R) has an effect like a diode (D_{R}) with respect to the second substrate region (S).

8. Protection structure according to Claim 4 or 5, characterized in that the resistor (R) essentially contains polysilicon.

9. Protection structure according to one of Claims 4 to 8, characterized in that the value of the resistor (R) is between 500 ohm and 1 kohm.

10. Protection structure according to one of Claims 4 to 9, characterized in that the filter element (1) contains a diode, preferably a gate-controlled diode such as a transistor (T), which is arranged between the circuit (4) of the circuit arrangement and the supply potential (VSS; VDD).

11. Protection structure according to Claim 10, characterized in that the transistor (T) is of the same conductance type (n; p) as the second substrate region (S).

12. Protection structure according to Claim 10 or 11, characterized in that the transistor is arranged in the same first substrate region (W) as the diodes (D1, D2) which are connected in opposition in series.

13. Protection structure according to one of the preceding claims, characterized in that said protection structure contains a further diode (D) which is arranged with the circuit (4) of the circuit arrangement and with a further supply potential (VDD; VSS) of the circuit arrangement.

## Revendications

1. Structure de protection contre des décharges électrostatiques pour un montage en technologie CMOS dans un substrat semiconducteur, dans laquelle au moins une diode et un circuit de lissage (1) agissant en tant que circuit RC sont branchés entre un plot de connexion (2) du montage et un potentiel d'alimentation (VSS; VDD) du montage, et dans laquelle le circuit de lissage est disposé, en outre, entre le plot de connexion (2) et un circuit (4) du montage, caractérisée par le fait que deux diodes (D1,D2) sont branchées, selon un montage anti-série, entre le plot de connexion (2) et un potentiel d'alimentation (VSS; VDD), les deux diodes (D1,D2) et la zone de raccordement commune (3) des diodes (D1,D2) étant dans une première région (W) du substrat, région qui a un premier type de conductivité, qui est placée à un potentiel flottant du point de vue électrique et qui est disposée dans une seconde région (S) du substrat ayant un second type de conductivité.

2. Structure de protection suivant la revendication 1, caractérisée par le fait que la première région (W) du substrat est disposée sur une surface principale de la seconde région (S) du substrat.

3. Structure de protection suivant la revendication 1, caractérisée par le fait que la première région (W) du substrat est ensevelie dans la seconde région (S) du substrat.

4. Structure de protection suivant l'une des revendications précédentes, caractérisée par le fait que le circuit de lissage (1) comporte une résistance (R), qui est disposée entre le plot de connexion (2) et le circuit (4) du montage.

5. Structure de protection suivant la revendication 4, caractérisée par le fait que la résistance (R) a une action capacitive (C_{R}) par rapport à la seconde région (S) du substrat.

6. Structure de protection suivant la revendication 4 ou 5, caractérisée par le fait que la résistance (R) est une résistance de diffusion.

7. Structure de protection suivant la revendication 6, caractérisée par le fait que la résistance (R) a une action (D_{R}) semblable à celle d'une diode par rapport à la seconde région (S) du substrat.

8. Structure de protection suivant la revendication 4 ou 5, caractérisée par le fait que la résistance (R) contient essentiellement du polysilicium.

9. Structure de protection suivant l'une des revendications 4 à 8, caractérisée par le fait que la valeur de la résistance (R) est comprise entre 500 ohm et 1 k.ohm.

10. Structure de protection suivant l'une des revendications 4 à 9, caractérisée par le fait que le circuit de lissage (1) comporte une diode, de préférence une diode commandée par la grille comme un transistor (T), et qui est disposée entre le circuit (4) du montage et le potentiel d'alimentation (VSS; VDD).

11. Structure de protection suivant la revendication 10, caractérisée par le fait que le transistor (T) a le même type de conductivité (n;p) que la seconde région (S) du substrat.

12. Structure de protection suivant la revendication 10 ou 11, caractérisée par le fait que le transistor est disposé dans la même première région (W) du substrat que les diodes (D1,D2) montées selon un montage anti-série.

13. Structure de protection suivant l'une des revendications précédentes, caractérisée par le fait qu'elle comporte une autre diode (D), qui est reliée au circuit (4) du montage et à un autre potentiel d'alimentation (VDD; VSS) du montage.
